(19) Europäisches Patentamt / European Patent Office / Office européen des brevets

(11) **EP 4 693 822 A1**

(12) **EUROPEAN PATENT APPLICATION**

(43) Date of publication:
**11.02.2026 Bulletin 2026/07**

(21) Application number: **25193224.0**

(22) Date of filing: **31.07.2025**

(51) International Patent Classification (IPC):
**H02J 50/12** (2016.01)   **H02J 50/40** (2016.01)
**H02J 50/60** (2016.01)

(52) Cooperative Patent Classification (CPC):
**H02J 50/12; H02J 50/40; H02J 50/402; H02J 50/60**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **05.08.2024   CN 202411064197**

(71) Applicant: **NXP USA, Inc.
Austin, TX 78735 (US)**

(72) Inventors:
• **Wang, Dechang**
  **5656AG Eindhoven (NL)**
• **Wang, Li**
  **5656AG Eindhoven (NL)**
• **Jiang, Dengyu**
  **5656AG Eindhoven (NL)**

(74) Representative: **Krott, Michel
  NXP Semiconductors
  Intellectual Property Group
  High Tech Campus 60
  5656 AG  Eindhoven (NL)**

(54) **WIRELESS CHARGING SYSTEM AND METHOD FOR SIMULTANEOUSLY MEASURING Q-VALUE**

(57)    A wireless charging system includes at least a first charging module and a second charging module. The first charging module includes a first coil module and a first controller unit. The first controller unit controls the first charging module to operate in a first mode and a second mode. The second charging module includes a second coil module and a second controller unit. The second controller unit controls the second charging module to operate in the first mode and the second mode. In response to one of the first charging module and the second charging module operating in the second mode, at least one of the first controller unit and second controller unit further: sets a corresponding one of the first charging module and the second charging module to operate at a first frequency; and sets the other one of the first charging module and the second charging module to operate at a second frequency different from the first frequency.

100

FIG. 1

(Cont. next page)

EP 4 693 822 A1

FIG. 3

## Description

## BACKGROUND

The present disclosure relates to a wireless charging system and a method for measuring Q-value in the wireless charging system.

Q-value, also known as Q-factor, is used in wireless charging systems for detecting foreign objects (FO). Generally, Q-value is obtained through injecting a pulse into a resonance tank of the wireless charging system, for triggering free resonance within the resonance tank, and measuring a decay rate of the free resonance signal in the resonance tank. For a wireless charging system which has multiple resonance tanks, for example multiple charging channels that are arranged adjacent to each other, the free resonance signal in one of the resonance tanks can easily be influenced by neighboring channels, and cause the measure Q-value to be inaccurate.

## SUMMARY

This summary is provided to introduce a selection of concepts in a simplified form that are further described below in the Detailed Description. This summary is not intended to identify key or essential features of the claimed subject matter, nor is it intended to be used to limit the scope of the claimed subject matter.

In accordance with a first aspect of the present disclosure, a wireless charging system includes at least a first charging module and a second charging module. The first charging module includes a first coil module and a first controller unit. The first controller unit is configured to control the first charging module to operate in a first mode and a second mode. The second charging module includes a second coil module and a second controller unit. The second controller unit is configured to control the second charging module to operate in the first mode and the second mode. In response to one of the first charging module and the second charging module operating in the second mode, at least one of the first controller unit and second controller unit is further configured to: set a corresponding one of the first charging module and the second charging module to operate at a first frequency; and set the other one of the first charging module and the second charging module to operate at a second frequency different from the first frequency.

In one or more embodiments, each of the first charging module and the second charging module is configured to wirelessly transmit power to a power sink when operating in the first mode; and each of the first charging module and the second charging module is further configured to determine a Q-value when operating in the second mode. In one or more embodiments, in response to the first charging module operating in the second mode: the first controller unit is configured to set the first charging module to operate at the first frequency determined by the first coil module; and the second controller unit is configured to set the second charging module to operate at the second frequency by applying a PWM driver signal to the second coil module. In one or more embodiments, the second controller unit is configured to set the second charging module to operate at the second frequency by applying a modified PWM driver signal to the second coil module such that the second frequency is different from the first frequency by at least 20%. In one or more embodiments, the second controller unit is configured to apply the modified PWM driver signal to the second coil module such that the second charging module operates in the first mode. In one or more embodiments, in response to the first charging module operating in the second mode: the first controller unit is configured to set the first charging module to operate at the first frequency by modifying, in the first coil module, at least one of an inductance and a capacitance; and the second controller unit is configured to set the second charging module to operate at the second frequency by applying a PWM driver signal to the second coil module. In one or more embodiments, the first coil module comprises an inductor and a capacitor that are connected in series; and the wireless charging system further comprises at least one additional inductor; wherein the first controller unit is configured to modify an inductance in the first coil module by coupling the at least one additional inductor in parallel with the inductor, such that the first charging module operates at the first frequency in the second mode. In one or more embodiments, the first coil module comprises an inductor and a capacitor that are connected in series; and the wireless charging system further comprises at least one additional capacitor; wherein the first controller unit is configured to modify a capacitance in the first coil module by coupling the at least one additional capacitor in parallel with the inductor, such that the first charging module operates at the first frequency in the second mode. In one or more embodiments, the first coil module comprises an inductor and a capacitor that are connected in series; and the wireless charging system further comprises at least one additional capacitor; wherein the first controller unit is configured to modify a capacitance in the first coil module by coupling the at least one additional capacitor in series with the capacitor, such that the first charging module operates at the first frequency in the second mode. In one or more embodiments, the first coil module comprises an inductor and a capacitor that are connected in series; and the wireless charging system further comprises at least one additional capacitor; wherein the first controller unit is configured to modify a capacitance in the first coil module by coupling the at least one additional capacitor in parallel with the capacitor, such that the first charging module operates at the first frequency in the second mode.

In accordance with a second aspect of the present disclosure, there is conceived a method for measuring a Q-value of a wireless charging channel in a wireless charging system. The wireless charging system includes multiple wireless charging channels. The method includes setting one of the multiple wireless charging channels to operate in a Q-measurement mode by: initiating resonance in a resonance circuit of the one of the multiple wireless charging channels at a resonance frequency; and setting a PWM frequency of a PWM driver signal provided to another one or more of the multiple wireless charging channels to transmit power in a charging mode. The method includes setting the resonance frequency to be different from the PWM frequency by one or both of: applying a modified PWM driver signal to the another one or more of the multiple wireless charging channels at the PWM frequency different from the resonance frequency of the resonance circuit; and reconfiguring the resonance circuit of the one of the multiple wireless charging channels such that the resonance frequency of the resonance circuit is different from the PWM frequency of the PWM driver signal provided to the another one or more of the multiple wireless charging channels.

In one or more embodiments, the method further comprises setting the resonance frequency to be different from the PWM frequency by at least 20%. In one or more embodiments, reconfiguring the resonance circuit of the one of the multiple wireless charging channels comprises coupling at least one additional inductor in parallel with an inductor of an LC resonance tank of the one of the multiple wireless charging channels.

In one or more embodiments, reconfiguring the resonance circuit of the one of the multiple wireless charging channels comprises coupling at least one additional capacitor in parallel with an inductor of an LC resonance tank of the one of the multiple wireless charging channels. In one or more embodiments, reconfiguring the resonance circuit of the one of the multiple wireless charging channels comprises coupling at least one additional capacitor in series with a capacitor of an LC resonance tank of the one of the multiple wireless charging channels. In one or more embodiments, reconfiguring the resonance circuit of the one of the multiple wireless charging channels comprises coupling at least one additional capacitor in parallel with a capacitor of an LC resonance tank of the one of the multiple wireless charging channels.

In accordance with a third aspect of the present disclosure, a wireless charging system includes multiple charging channels and a controller module. The multiple charging channels are each operable in a first mode in which the charging channel wirelessly transmits power to a power sink; and a second mode in which the charging channel measures a Q-value. The controller module includes one or more controller units connectable to the multiple charging channels. The one or more controller units are configured to: provide a PWM driver signal at a first frequency to the connected charging channel for the connected charging channel to operate in the first mode; and provide an initial pulse to the connected charging channel for the connected charging channel to operate in the second mode and resonate at a second frequency determined by a configuration of the connected charging channel. The controller module is configured to differentiate the first frequency of the PWM driver signal provided to a first charging channel operating in the first mode and the second frequency in which a second charging channel operating in the second mode resonates by either or both of: providing a modified PWM driver signal to the first charging channel; and modifying the configuration of the second charging channel such that the second frequency at which the second charging channel resonates is determined by the modified configuration.

In one or more embodiments, the controller module is configured to modify the configuration of the second charging channel by at least one of: coupling at least one additional inductor in parallel with an inductor of an LC resonance tank of the second charging channel; coupling at least one additional capacitor in parallel with an inductor of an LC resonance tank of the second charging channel; coupling at least one additional capacitor in series with a capacitor of an LC resonance tank of the second charging channel; and coupling at least one additional capacitor in parallel with a capacitor of an LC resonance tank of the second charging channel. In one or more embodiments, the controller module is configured to differentiate the first frequency and the second frequency by at least 20%. In one or more embodiments, the controller module is configured to: provide the PWM driver signal at a frequency of 126kHz for the connected charging channel to operate in the first mode; and in response to one of the multiple charging channels operating in the second mode, provide the modified PWM driver signal at a frequency of 80kHz for the connected charging channel to operate in the first mode.

BRIEF DESCRIPTION OF THE DRAWINGS

So that the manner in which the above recited features of the present disclosure can be understood in detail, a more detailed description of the disclosure may be had by reference to embodiments, some of which are illustrated in the appended drawings. The appended drawings illustrate only typical embodiments of the disclosure and should not limit the scope of the disclosure, as the disclosure may have other equally effective embodiments. The drawings are for facilitating an understanding of the disclosure and thus are not necessarily drawn to scale. Advantages of the subject matter claimed will become apparent to those skilled in the art upon reading this description in conjunction with the accompanying drawings, in which like reference numerals have been used to designate like elements, and in which:

Fig. 1 is a block diagram of a wireless charging system according to an embodiment;

Fig. 2 is a schematic diagram of a charging channel of Fig. 1;

Fig. 3 is a schematic diagram of a charging channel and additional inductors of the system according to an embodiment;

Fig. 4 is a schematic diagram of a charging channel and an additional capacitor of the system according to an embodiment;

Fig. 5 is a schematic diagram of a charging channel and an additional capacitor of the system according to an embodiment; and

Fig. 6 is a schematic diagram of a charging channel and an additional capacitor of the system according to an embodiment.

DETAILED DESCRIPTION

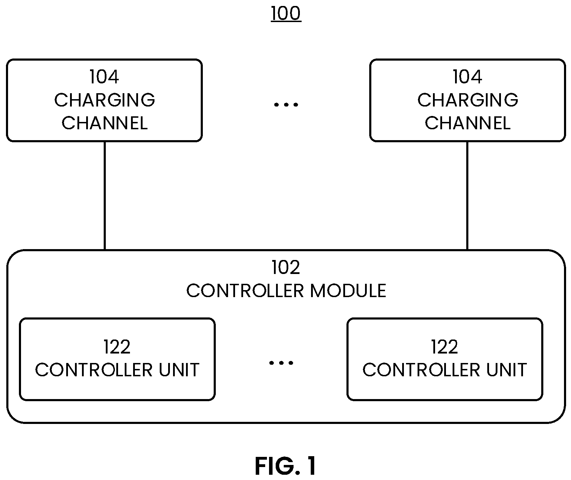

Fig. 1 is a block diagram of a wireless charging system according to an embodiment. The system 100 includes a controller module 102 and multiple charging channels 104. The controller module 102 includes one or more controller units 122 each of which is connectable to a corresponding one of the multiple charging channels 104. The controller unit 122 may be dynamically connected to one of the multiple charging channels 104 as required. That is to say, although the controller unit 122 connects to one of the charging channels 104 at a time, the controller unit 122 may be connectable to different ones of the charging channels 104 at different moments. A complete charging module of the system 100 includes a controller unit 122 and a corresponding charging channel 104 when the controller unit 122 is connected to the corresponding charging channel 104. In the charging module, the controller unit 122 causes the charging channel 104 to operate, at any moment in time, in one of a group of modes, which group of modes includes at least a first mode and a second mode. In the first mode, the charging channel 104 wirelessly transmits power to a power sink, for example a power receiver (not shown). In the second mode, the charging channel 104 measures a Q-value.

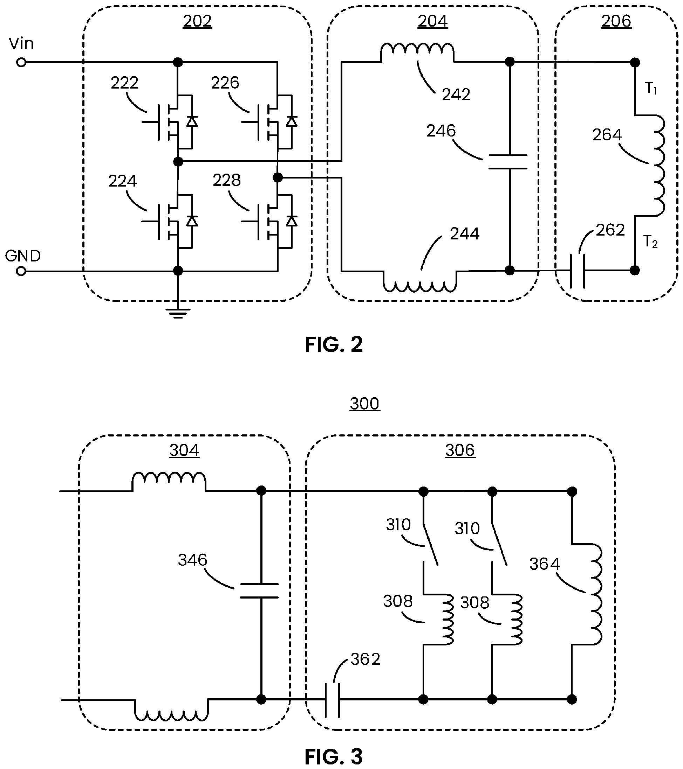

Referring to Fig. 2, this shows a schematic diagram of a charging channel 104 of Fig. 1. The charging channel is coupled between a supply terminal Vin and ground GND. The charging channel includes a switch module 202, a filter module 204, and a coil module 206. The switch module 202 includes one or more switches 222, 224, 226, and 228 that are controlled by the corresponding connected controller unit of the controller module, to supply a voltage from the supply terminal Vin to the coil module 206 by way of the filter module 204. In the example of Fig. 2, the switches 222 and 224 are connected in series between the supply terminal Vin and ground GND, and the switches 226 and 228 are also connected in series between the supply terminal Vin and ground GND. The switches 222-228 are MOSFETs in the example, and may be implemented as other switching means, without limitation. The filter module 204 is typically a PI filter, and includes a first inductor 242, a second inductor 244, and a capacitor 246. The first inductor 242 and the second inductor 244 are connected to opposite sides of the capacitor 246. The coil module 206 includes a capacitor 262 and an inductor 264 that are connected in series. The inductor 264 is a coil in the example. Upon receiving the supplied voltage, the inductor 264 produces a magnetic field that carries power to be transmitted to a coupled power sink.

The controller unit 122 of the controller module 102 provides a Pulse Width Modulation (PWM) signal to the switch module 202 of the charging channel. Accordingly, a driver signal from the switch module 202 to the coil module 206 has a switching frequency, and is used for manipulating the coil module 206. Specifically, in the example of Fig. 2, during a cycle of operation of the coil module 206, switches 222 and 228 become conductive first, to provide a voltage to the inductor 264 from a terminal $T_1$ to a terminal $T_2$ thereof, in the meantime switches 224 and 226 are open. Then, switches 222 and 228 are controlled to be open, while switches 224 and 226 become conductive, to provide a voltage to the inductor 264 in an opposite direction, from the terminal $T_2$ to the terminal $T_1$. A frequency of the PWM signal, and accordingly a frequency in which the coil module 206 operates to transmit power, is typically chosen to be about 127kHz, and so to be compliant to the Qi standard by Wireless Power Consortium (WPC).

Q-value, also referred to as Quality value, of a resonance refers to the "sharpness" of the resonance and refers to the ratio of the resonance center-frequency, to its half-power bandwidth. It is known to be indicative of whether a foreign object is present in the magnetic field of the coil. Q-value can be measured by injecting an initial pulse into the coil module 206, and then switch off all the switches 222-228 in the switch module 202, so that there is initiated a free resonance in a resonance tank consisting of the capacitor 246 of the filter module 204, the capacitor 262 and the inductor 264 of the coil module 206. Accordingly, a resonance frequency is determined by the configuration of the resonance tank, *i.e.* by the capacitances of the capacitor 246 and the capacitor 262, and the inductance of the inductor 264. If there is a foreign object within a receiving distance of the inductor 264, the resonance in the resonance tank attenuates faster than in situations where there is no such foreign object, corresponding to a lower Q-value. The system 100 measures the Q-value for the charging channels 104 from time to time. For example, the Q-value may be measured periodically, or may be measured when there is a requirement to detect if a foreign object is present.

According to the embodiment, the controller module 102 distinguishes the operation frequency of one charging channel from the resonance frequency of a neighboring charging channel, to avoid interference between the operating charging channel and its neighboring resonating charging channel, and thereby avoids distortion in the Q-value measurement. In the example, the controller module 102 differentiates, that is to say it ensures a separation between, the operation frequency and the resonance frequency of the respective neighboring charging channels by at least 20%. In other examples, the controller module 102 sets the difference between the operation frequency and the resonance frequency according to the physical distance between the charging channels, due to that the interference between charging channels attenuates with increasing distance.

In detail, the controller module 102 provides a modified PWM signal to a connected charging channel operating in its first mode, such that the charging channel operates at a modified frequency, for example around 80kHz, which is distinguished from a resonance frequency at which a neighboring charging channel 104 operating in its second mode resonates. Alternatively or additionally, the controller module 102 switches the charging channel 104 operating in the second mode into a different configuration such that the resonance frequency in which the charging channel 104 resonates is different enough from the frequency in which the neighboring charging channel 104 operates in the first mode. The controller module 102 may be implemented for changing either one of, or both of the frequency of operation for the charging channel 104 operating in the first mode and the frequency of resonance for the charging channel 104 operating in the second mode, to distinguish the frequencies by 20%.

Switching the connected charging channel 104 into a different configuration may be implemented in various ways. Fig. 3 is a schematic diagram of a charging channel and additional inductors of the system according to an embodiment. In the system 300, the charging channel is similar to the charging channel 104 of Fig. 2, and the similar components are similarly labelled. The system 300 further includes one or more additional inductors 308 that are connected in parallel with the inductor 364 of the coil module 306. Each of the one or more additional inductors 308 is connected in series with a switch 310. One terminal of the additional inductor 308 is connected to a node between the capacitor 362 and the inductor 364 of the coil module 306, and the other terminal of the additional inductor 308 is coupled to the other terminal of the inductor coil 364 by way of a corresponding switch 310. The switch or switches 310 is or are controlled by a controller unit of the controller module connected to the charging channel. The switch or switches 310 is or are open when the charging channel of the system 300 operates in the first mode to wirelessly transmit power. During the second mode of Q-value measurement, by closing one or more of the switch or switches 310, one or more of the additional inductor or inductors 308 is added into the resonance tank of the inductor 364, the capacitor 362, and the capacitor 346 of the filter module 304.

Adding the additional one or more inductors 308 into the resonance tank changes the resonance frequency. As known, the resonance frequency $f$ of the resonance tank is determined by the inductance $L$ of the inductor and the capacitance $C$ of the capacitor in the tank: $f = \frac{1}{2\pi\sqrt{LC}}$. By coupling one or more additional inductor 308 with a total additional inductance of $L_2$ in parallel with the inductor 364 with an inductance of $L_1$, the inductance $L_T$ of the resonance tank for determining the resonance frequency is: $L_T = \frac{L_1 \times L_2}{L_1 + L_2}$. Inductance $L_2$ of the additional inductor or inductors 308 is determined according to the inductor $L_1$ of the inductor 364, such that when the additional inductor 308 is coupled into the resonance tank by closing the switch or switches 310, the resonance frequency of the resonance tank changes. In an example, each of the multiple charging channels may include respective one or more additional inductors 308. In another example, the system 300 may include the one or more additional inductors 308 that are connectable to one of the multiple charging channels, to be usable in common by the multiple charging channels. In other examples, the one or more additional inductors 308 may be coils that are similar to the inductor 364, to provide the modified inductances to the resonance tank.

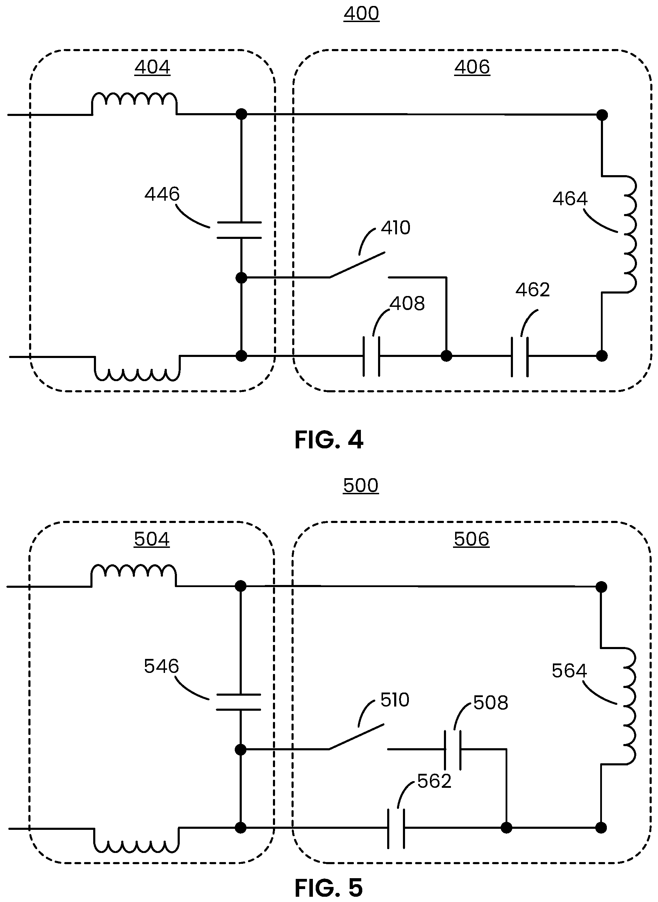

Fig. 4 is a schematic diagram of a charging channel and an additional capacitor of the system according to an embodiment. In the system 400, the charging channel is similar to the charging channel of Fig. 2, and the similar components are similarly labelled. The system 400 further includes an additional capacitor 408 which is connected in series with the capacitor 462 of the coil module 406. In details, the additional capacitor 408 is connected between the capacitor 462 and the filter module 404. A switch 410 is connected in parallel with the additional capacitor 408, and is controlled by the controller unit of the controller module (not shown) of the system 400. The switch 410 is closed during the first mode of operation of the system 400 in which mode power is transmitted wirelessly to a receiver. When the charging channel operates in the second mode to measure its Q-value, the switch 410 becomes open so that the additional capacitor 408 is connected into the system. The additional capacitor 408 couples a capacitance into the resonance tank of the inductor coil 464 and the capacitor 462 of the coil module 406 and the capacitor 446 of the filter module 404. Connecting the additional capacitor 408 having a capacitance of $C_2$ with the inherent capacitor 462 having a capacitance of $C_1$ causes the capacitance $C_T$ for determining the resonance frequency of the resonance tank to be $C_T = \frac{C_1 \times C_2}{C_1 + C_2}$, which is changed with regard to the inherent capacitance of the capacitor 462. Accordingly, coupling the additional capacitor 408 into the charging channel operating in the second mode changes the resonance frequency which is distinguished from the operation frequency of a neighboring charging channel operating in the first mode. When the charging channel exits the second mode, and either becomes idle or operates in the first mode, the switch 410 is controlled to be closed to short the additional capacitor 408. Shorting the additional capacitor 408 when the charging channel exits operating in the second mode does not couple the additional capacitance into the circuit.

Fig. 5 is a schematic diagram of a charging channel and an additional capacitor of the system according to an embodiment. In the system 500, the charging channel is similar to the charging channel of Fig. 4, and the similar components are similarly labelled. The system 500 further includes an additional capacitor 508 which is connected in series with a switch 510. The series connection of the additional capacitor 508 and the switch 510 is connected in parallel with the capacitor 562 of the coil module 506 of the system 500. A terminal of the additional capacitor 508 is connected to a node between the capacitor 562 and the inductor coil 564 of the coil module 506, and the other terminal of the additional capacitor 508 is connected to the switch 510. The switch 510 connects, at the other terminal thereof, to a node between the capacitor 562 and the filter module 504. Similar to the examples described above, the switch 510 is controlled by the corresponding controller unit of the controller module (not shown) of the system 500. When the charging channel operates in the second mode to measure its Q-value, the switch 510 becomes closed, and the additional capacitor 508 is connected in parallel with the capacitor 562. As is known, connecting the additional capacitor 508 having a capacitance of $C_2$ in parallel with the capacitor 562 having a capacitance of $C_1$ causes the capacitance $C_T$ for determining the resonance frequency of the resonance tank to be $C_T = C_1 + C_2$, which accounts a change with regard to the inherent capacitance of the capacitor 562. It is known that the resonance frequency of the resonance tank according to the typical configuration of the Qi standard is around 127kHz, and is comparable to the operation frequency of a neighboring charging channel in transmitting the power. By coupling the additional capacitor 508, the resonance frequency may be changed to around 80kHz, which is distinguished from the operation frequency of the neighboring charging channel. On the other hand, when the charging channel exits operating in the second mode, for example becomes idle or operates in the first mode, the switch 510 becomes open such that the additional capacitor 508 is not coupled in the circuit.

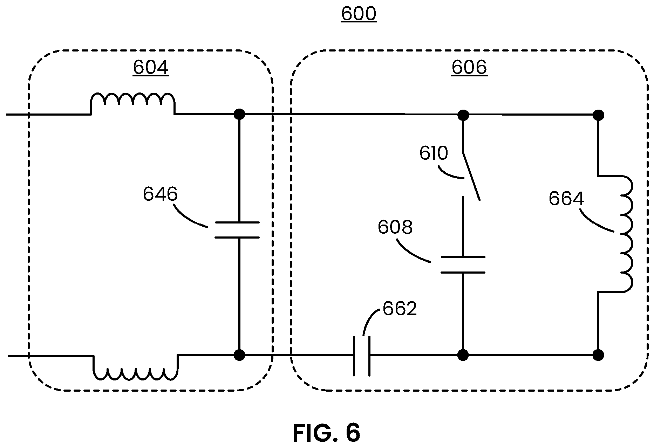

Fig. 6 is a schematic diagram of a charging channel and an additional capacitor of the system according to an embodiment. In the system 600, the charging channel is similar to the charging channel of Fig. 2 and Fig. 3, and the similar components are similarly labelled. The system 600 further includes one or more additional capacitors 608 that are connected in parallel with the inductor coil 664 of the coil module 606. Fig. 6 illustrates an example with a single such additional capacitor 608. Each of the one or more additional capacitors 608 is connected in series with a corresponding switch 610. One terminal of the additional capacitor 608 is connected to a node between the inductor 664 and the capacitor 662 of the coil module 606, and the other terminal of the additional capacitor 608 is coupled with a node between the inductor 664 and the filter module 604 by way of the switch 610.

The switch 610 is controlled by a controller module (not shown) connected to the charging channel. By closing the switch 610, the additional capacitor 608 is coupled into the resonance tank of the inductor 664 and the capacitor 662 of the coil module 606, and the capacitor 646 of the filter module 604. Coupling the additional capacitor 608 into the resonance tank changes the resonance frequency which is determined by the inductance and the capacitance in the resonance tank. An equivalent capacitance $C_T$ in the resonance tank after coupling the additional capacitor 608 in is:

$$C_T = \frac{C_F \times C_1}{C_F + C_1} + C_2$$

, wherein $C_F$ is the capacitance of the capacitor 646 of the filter module 604, $C_1$ is the capacitance of the capacitor 662 of the coil module 606, and $C_2$ is the capacitance of the additional capacitor 608. On the other hand, when the charging channel exits operating in the second mode, for example becomes idle or operates in the first mode, the switch 610 becomes open such that the additional capacitor 608 is disconnected from the circuit.

It is now understood that the examples of Fig. 3, Fig. 4, Fig. 5, and Fig. 6 change the frequency of the charging channel when operating in the second mode to measure the Q-value, such that the changed frequency differentiates from the frequencies in that neighboring charging channels operate in the first mode. It is appreciated that other means of changing the frequency by modifying the inductance or capacitance of the resonance tank may be applicable, for example a switch under the control of a corresponding controller module may be coupled in parallel with the capacitor of the coil module or the capacitor of the filter module, to be closed during the Q-measurement mode and short the inherent capacitor from the resonance tank. The configurations as described above may be combined and implemented together in various ways, in order to modify the resonance frequency of the charging channel.

Referring back to Fig. 1, the controller module 102 is configured such that the controller units 122, when connecting to corresponding charging channels, are synchronized and communicated. In details, when one of the charging channels start to operate in the second mode to measure the Q-value, other controller units 122 acknowledge that the specific charging channel operate in the Q-value measurement mode, and the controller units 122 operate to differentiate the frequencies of those charging channels transmitting wireless power from the frequency of the Q-value measuring channel.

The use of the terms "a" and "an" and "the" and similar referents in the context of describing the subject matter (particularly in the context of the following claims) are to be construed to cover both the singular and the plural, unless otherwise indicated herein or clearly contradicted by context. The terms "coupled" and "connected" both mean that there is an electrical connection between the elements being coupled or connected, and neither implies that there are no intervening elements. Recitation of ranges of values herein are intended merely to serve as a shorthand method of referring individually to each separate value falling within the range, unless otherwise indicated herein, and each separate value is incorporated into the specification as if it were individually recited herein. Furthermore, the foregoing description is for the purpose of illustration only, and not for the purpose of limitation, as the scope of protection sought is defined by the claims set forth hereinafter together with any equivalents thereof entitled to. The use of any and all examples, or exemplary language (e.g., "such as") provided herein, is intended merely to better illustrate the subject matter and does not pose a limitation on the scope of the subject matter unless otherwise claimed. The use of the term "based on" and other like phrases indicating a condition for bringing about a result, both in the claims and in the written description, is not intended to foreclose any other conditions that bring about that result. No language in the specification should be construed as indicating any non-claimed element as essential to the practice of the disclosure as claimed.

Preferred embodiments are described herein, including the best mode known to the inventor for carrying out the claimed subject matter. Of course, variations of those preferred embodiments will become apparent to those of ordinary skill in the art upon reading the foregoing description. The inventor expects skilled artisans to employ such variations as appropriate, and the inventor intends for the claimed subject matter to be practiced otherwise than as specifically described herein. Accordingly, this claimed subject matter includes all modifications and equivalents of the subject matter recited in the claims appended hereto as permitted by applicable law. Moreover, any combination of the above-described elements in all possible variations thereof is encompassed unless otherwise indicated herein or otherwise clearly contradicted by context.

**Claims**

1. A wireless charging system comprising at least a first charging module and a second charging module;

wherein:

the first charging module comprises a first coil module, and a first controller unit configured to control the first charging module to operate in a first mode and a second mode;
the second charging module comprises a second coil module, and a second controller unit configured to control the second charging module to operate in the first mode and the second mode; wherein
in response to one of the first charging module and the second charging module operating in the second mode, at least one of the first controller unit and second controller unit is further configured to:

set a corresponding one of the first charging module and the second charging module to operate at a first frequency; and
set the other one of the first charging module and the second charging module to operate at a second frequency different from the first frequency.

2. The wireless charging system of claim 1, wherein

each of the first charging module and the second charging module is configured to wirelessly transmit power to a power sink when operating in the first mode; and
each of the first charging module and the second charging module is further configured to determine a Q-value when operating in the second mode.

3. The wireless charging system of claim 1 or 2, wherein in response to the first charging module operating in the second mode:

the first controller unit is configured to set the first charging module to operate at the first frequency determined by the first coil module; and
the second controller unit is configured to set the second charging module to operate at the second frequency by applying a PWM driver signal to the second coil module.

4. The wireless charging system of claim 3, wherein the second controller unit is configured to set the second charging module to operate at the second frequency by applying a modified PWM driver signal to the second coil module such that the second frequency is different from the first frequency by at least 20%.

5. The wireless charging system of claim 4, wherein the second controller unit is configured to apply the modified PWM driver signal to the second coil module such that the second charging module operates in the first mode.

6. The wireless charging system of any preceding claim, wherein in response to the first charging module operating in the second mode:

the first controller unit is configured to set the first charging module to operate at the first frequency by modifying, in the first coil module, at least one of an inductance and a capacitance; and
the second controller unit is configured to set the second charging module to operate at the second frequency by applying a PWM driver signal to the second coil module.

7. The wireless charging system of claim 6, wherein

the first coil module comprises an inductor and a capacitor that are connected in series; and wherein
the wireless charging system further comprises at least one additional inductor;
wherein the first controller unit is configured to modify an inductance in the first coil module by coupling the at least one additional inductor in parallel with the inductor, such that the first charging module operates at the first frequency in the second mode.

8. The wireless charging system of claim 6, wherein

the first coil module comprises an inductor and a capacitor that are connected in series; and wherein
the wireless charging system further comprises at least one additional capacitor;
wherein the first controller unit is configured to modify a capacitance in the first coil module by coupling the at least one additional capacitor in parallel with the inductor, such that the first charging module operates at the first frequency in the second mode.

9. The wireless charging system of claim 6, wherein

the first coil module comprises an inductor and a capacitor that are connected in series; and wherein
the wireless charging system further comprises at least one additional capacitor;
wherein the first controller unit is configured to modify a capacitance in the first coil module by coupling the at least one additional capacitor in series with the capacitor, such that the first charging module operates at the first frequency in the second mode.

10. The wireless charging system of claim 6, wherein

the first coil module comprises an inductor and a capacitor that are connected in series; and wherein
the wireless charging system further comprises at least one additional capacitor;
wherein the first controller unit is configured to modify a capacitance in the first coil module by coupling the at least one additional capacitor in parallel with the capacitor, such that the first charging module operates at the first frequency in the second mode.

11. A method for measuring a Q-value of a wireless charging channel in a wireless charging system comprising multiple wireless charging channels, wherein the method comprises setting one of the multiple wireless charging channels to operate in a Q-measurement mode by:

initiating resonance in a resonance circuit of the one of the multiple wireless charging channels at a resonance frequency; and
setting a PWM frequency of a PWM driver signal provided to another one or more of the multiple wireless charging channels to transmit power in a charging mode; and wherein the method further comprises setting the resonance frequency to be different from the PWM frequency by one or both of:

applying a modified PWM driver signal to the another one or more of the multiple wireless charging channels at the PWM frequency different from the resonance frequency of the resonance circuit; and
reconfiguring the resonance circuit of the one of the multiple wireless charging channels such that the resonance frequency of the resonance circuit is different from the PWM frequency of the PWM driver signal provided to the another one or more of the multiple wireless charging channels.

12. The method of claim 11, further comprising setting the resonance frequency to be different from the PWM frequency by at least 20%.

13. The method of claim 11 or 12, wherein reconfiguring the resonance circuit of the one of the multiple wireless charging channels comprises coupling at least one additional inductor in parallel with an inductor of an LC resonance tank of the one of the multiple wireless charging channels.

14. The method of claim 11 or 12, wherein reconfiguring the resonance circuit of the one of the multiple wireless charging channels comprises coupling at least one additional capacitor in parallel with an inductor of an LC resonance tank of the one of the multiple wireless charging channels.

15. The method of claim 11 or 12, wherein reconfiguring the resonance circuit of the one of the multiple wireless charging channels comprises coupling at least one additional capacitor in series with a capacitor of an LC resonance tank of the one of the multiple wireless charging channels.

100

| 104<br>CHARGING<br>CHANNEL | ... | 104<br>CHARGING<br>CHANNEL |

102
CONTROLLER MODULE

| 122<br>CONTROLLER UNIT | ... | 122<br>CONTROLLER UNIT |

FIG. 1

**FIG. 2**

**300**

**FIG. 3**

400

404

446

410

408

462

464

406

**FIG. 4**

500

504

546

510

562

508

564

506

**FIG. 5**

FIG. 6

# EP 4 693 822 A1

| | Europäisches Patentamt<br>European Patent Office<br>Office européen des brevets | **EUROPEAN SEARCH REPORT** | **Application Number**<br>EP 25 19 3224 |
|---|---|---|---|

## DOCUMENTS CONSIDERED TO BE RELEVANT

| Category | Citation of document with indication, where appropriate,<br>of relevant passages | Relevant<br>to claim | CLASSIFICATION OF THE<br>APPLICATION (IPC) |
|---|---|---|---|
| X | US 11 081 900 B2 (GEN ELECTRIC [US])<br>3 August 2021 (2021-08-03) | 1,3-5 | INV.<br>H02J50/12<br>H02J50/40<br>H02J50/60 |
| Y | * page 3, column 1 - page 10, column 10 * | 2,6-10 | |
| Y | ANONYMOUS: "Qi Specification - Power<br>Delivery (Version 1.3)",<br>WIRELESS POWER CONSORTIUM,<br>1 January 2021 (2021-01-01), XP093212389,<br>* page 56 - page 89 * | 2 | |
| X | US 2022/416589 A1 (WANG DECHANG [CN] ET<br>AL) 29 December 2022 (2022-12-29)<br>* page 1 - page 6 * | 1-5,<br>11-15 | |
| Y | EP 3 696 941 A1 (LG ELECTRONICS INC [KR])<br>19 August 2020 (2020-08-19)<br>* page 3, paragraph 0015 - page 19,<br>paragraph 0015 * | 6-10 | |

| | TECHNICAL FIELDS<br>SEARCHED (IPC) |
|---|---|
| | H02J |

The present search report has been drawn up for all claims

| Place of search | Date of completion of the search | Examiner |
|---|---|---|
| Munich | 24 November 2025 | Reissner, Florian |

## ANNEX TO THE EUROPEAN SEARCH REPORT
## ON EUROPEAN PATENT APPLICATION NO.

EP 25 19 3224

This annex lists the patent family members relating to the patent documents cited in  the above-mentioned European search report.
The members are as contained in the European Patent Office EDP file on
The European Patent Office is in no way liable for these particulars which are merely given for the purpose of information.

24-11-2025

| Patent document cited in search report | | Publication date | Patent family member(s) | | Publication date |
|---|---|---|---|---|---|
| US 11081900 | B2 | 03-08-2021 | US | 2019326769 A1 | 24-10-2019 |
| | | | WO | 2018111421 A1 | 21-06-2018 |
| US 2022416589 | A1 | 29-12-2022 | CN | 115528822 A | 27-12-2022 |
| | | | US | 2022416589 A1 | 29-12-2022 |
| EP 3696941 | A1 | 19-08-2020 | EP | 3696941 A1 | 19-08-2020 |
| | | | KR | 20200099916 A | 25-08-2020 |
| | | | US | 2020266671 A1 | 20-08-2020 |

EPO FORM P0459

For more details about this annex : see Official Journal of the European Patent Office, No. 12/82